# EUROPÄISCHE PATENTSCHRIFT

(11) **EP 1 968 890 B1**
(45) Veröffentlichungstag und Bekanntmachung des Hinweises auf die Patenterteilung: **09.02.2011**
(21) Anmeldenummer: 06776709.5
(22) Anmeldetag: 09.08.2006
(51) Int. Cl.: C01B 33/037, C01B 33/02, C01B 33/021, C01B 33/025, B22D 27/04, H01L 31/00, C30B 11/00

(54) **VERFAHREN ZUR HERSTELLUNG SOLARTAUGLICHEN SILIZIUMS**
METHOD FOR THE PRODUCTION OF SILICON SUITABLE FOR SOLAR PURPOSES
PROCEDE DE PRODUCTION DE SILICIUM A USAGE SOLAIRE

(30) Priorität: 21.12.2005 DE 102005061690
(43) Veröffentlichungstag der Anmeldung: 17.09.2008
(73) Patentinhaber: centrotherm SiTec GmbH, 89143 Blaubeuren (DE)
(72) Erfinder: FATH, Peter, 78464 Konstanz (DE); MOZER, Albrecht, 84489 Burghausen (DE)
(74) Vertreter: Heyerhoff, Markus
(86) Internationale Anmeldenummer: PCT/EP2006/007885
(87) Internationale Veröffentlichungsnummer: WO 2007/079789

(56) Entgegenhaltungen:
- WO-A-2005/063621
- DE-A1- 3 611 950
- EYER A ET AL COMMISSION OF THE EUROPEAN COMMUNITIES: "LOCALIZATION OF THE SOLID/LIQUID INTERFACE DURING DIRECTIONAL SOLIDIFICATION OF SILICON BY A PULSE-ECHO ULTRASONIC TECHNIQUE" 10TH. E.C. PHOTOVOLTAIC SOLAR ENERGY CONFERENCE. LISBON, PORTUGAL, APRIL 8 - 12, 1991, PROCEEDINGS OF THE INTERNATIONAL PHOTOVOLTAIC SOLAR ENERGY CONFERENCE, DORDRECHT, KLUWER ACADEMIC PUBLISHERS, NL, Bd. CONF. 10, 8. April 1991 (1991-04-08), Seiten 295-297, XP001135686 ISBN: 0-7923-1389-5

## Beschreibung

Die Erfindung betrifft ein Verfahren zum Herstellen solartauglichen Siliziums gemäß dem Oberbegriff des Anspruchs 1.

Die Photovoltaikindustrie verzeichnete in den vergangenen Jahren ein starkes Wachstum. Da Silizium derzeit das wichtigste Ausgangsmaterial für die Herstellung von Solarzellen bzw. Solarmodulen ist, ist die Nachfrage nach diesem Rohstoff stark gestiegen.

Silizium kommt in der Natur in Form von Siliziumdioxid häufig vor, so dass kein prinzipielles Versorgungsproblem besteht. Es bedarf jedoch der Siliziumgewinnung aus Siliziumdioxid, wobei das benötigte Silizium eine gewisse Reinheit aufweisen muss, damit hieraus brauchbare Solarzellen mit entsprechendem Wirkungsgrad gefertigt werden können.

Im Vergleich mit den in der Elektronikindustrie für die Fertigung von Halbleiterbauelementen wie Prozessoren, Speichern, Transistoren etc. erforderlichen Reinheiten, sind die Anforderungen, welche die Photovoltaikindustrie an die Reinheit des für die Herstellung von kommerziellen Siliziumsolarzellen, insbesondere multikristallinen Siliziumsolarzellen, verwendeten Siliziums stellt, deutlich geringer. Dieses solartaugliche oder solar grade silicon genannte Silizium sollte bezogen auf die wesentlichen Verunreinigungen bei Dotierstoffen (P, B) und Metallen Konzentrationen im bereich von höchstens 100 ppb (parts per billion) und bei Kohlenstoff und Sauerstoff Konzentrationen im Bereich von höchstens mehreren ppm (parts per million) aufweisen.

Damit liegen die Reinheitsanforderungen etwa um den Faktor 100 unter denjenigen, welche die Elektronikindustrie an ihr Ausgangsmaterial stellt. Aus diesem Grund wurde in der Vergangenheit das Abfallmaterial der Elektronikindustrie in der Photovoltaikindustrie weiterverarbeitet. Im Zuge des starken Wachstums der Photovoltaikindustrie reichen jedoch zwischenzeitlich die zur Verfügung stehenden Mengen an diesem Abfallsilizium nicht mehr aus, um die Nachfrage zu decken. Daher besteht Bedarf an Verfahren zur kostengünstigen Herstellung von Silizium, welches den Anforderungen der Photovoltaikindustrie (PV-Industrie) genügt, d.h. solartauglichem Silizium.

In der Vergangenheit wurde hierzu hauptsächlich der Weg beschritten, der auch in der Herstellung von Silizium für die Elektronikindustrie Verwendung findet. Hierbei wird mittels carbothermischer Reduktion von Siliziumdioxid mit Kohlenstoff zunächst metallurgisches Silizium hergestellt. Im weiteren wird aus dem metallurgischen Silizium eine Silanverbindung gewonnen. Nach deren Reinigung erfolgt in einem chemischen Verfahren die Abscheidung von Silizium aus der Gasphase der Silanverbindung. Dieses Silizium wird üblicherweise aufgeschmolzen und zu in der PV-Industrie weiterverarbeitbaren Blöcken gegossen oder in Stäbe gezogen.

Neben diesem energie- und kostenaufwändigen Verfahren wird in anderen Verfahren das deutlich unreinere metallurgische Silizium als Ausgangsmaterial verwendet. Dieses ist etwa um den Faktor 1000 unreiner als es die Anforderungen an solartaugliches Silizium erlauben. Daher wird das metallurgische Silizium in verschiedenen Verfahrensschritten aufbereitet. Dabei kommen hauptsächlich metallurgische bzw. chemische Verfahren wie die Durchleitung von Spülgasen, insbesondere oxidierenden Spülgasen, und/oder Säuren durch aufgeschmolzenes metallurgisches Silizium und/oder die Zusetzung von Schlackebildnern zum Einsatz. Ein solches Verfahren ist beispielsweise in der EP 0 867 405 B1 beschrieben.

In beiden grundsätzlichen Verfahren wird jedoch eine Siliziumschmelze zu weiterverarbeitbaren Blöcken gegossen. Dabei erstarrt die Siliziumschmelze. Erfolgt diese Erstarrung gerichtet, so lässt sich der Effekt unterschiedlicher Löslichkeit von Verunreinigungen in der Siliziumschmelze und dem Siliziumfestkörper ausnutzen. Bei einer Vielzahl relevanter Verunreinigungen liegt eine höhere Löslichkeit in der flüssigen als der festen Phase vor. Der sogenannte Segregationseffekt lässt sich daher zur Reinigung des Siliziummaterials ausnutzen, indem bei einer gerichteten Erstarrung die Verunreinigungen in der Erstarrungs- oder Kristallisationsfront vor dem erstarrten Silizium gesammelt und vor der Kristallisationsfront hergetrieben werden. Nach vollständiger Erstarrung sind die Verunreinigungen sodann in dem zuletzt erstarrten Bereich des Siliziumblocks konzentriert und können einfach abgetrennt werden. Die Reinigungswirkung kann dabei durch mehrfach hintereinander folgendes Aufschmelzen und gerichtetes Erstarren erhöht werden.

Die Patentanmeldung DE 3611950 und WO 2005063621 offenbaren dabei zum Beispiel allgemein solche Reinigungsverfahren für Silizium bei denen eine Erstarrung der Siliziumschmelze gerichtet erfolgt.

Darüber hinaus offenbart der Artikel "Localization of the solid/liquid interface during directional solidification of silicon by a pulse-echo ultrasonic technique" (Eyer et al., 10th E.C. Photovoltaic solar energy conference, Lisbon, Portugal, April 8-12, 1991, Proceedings of the international photovoltaic solar energy conference, Kluwer Academic Publishers, vol. conf. 10, 08-04-1991, Seiten 295-297) ein Reinigungsverfahren für Silizium, bei dem eine Erstarrung der Siliziumschmelze gerichtet erfolgt, wobei die besten Resultate mit einer bevorzugt flachen oder leicht konvexen Erstarrungsfront erwartet werden.

Die Abscheidung von Silizium aus der Dampfphase von Silanverbindungen ist, wie bereits erwähnt, kostenintensiv und energetisch aufwändig. Die Aufbereitung metallurgischen Siliziums kann energetisch günstiger sein, jedoch muss eine Vielzahl von Aufbereitungsschritten durchgeführt werden, um die an solartaugliches Silizium gestellten Reinheitsanforderungen einzuhalten.

Der vorliegenden Erfindung liegt daher das Problem zugrunde, ein Herstellungsverfahren für solartaugliches Silizium zur Verfügung zu stellen, welches eine aufwandsgünstige Herstellung von solartauglichem Silizium ermöglicht,

Dieses Problem wird erfindungsgemäß gelöst durch ein Verfahren mit den Merkmalen des Anspruchs 1.

Vorteilhafte Weiterbildungen sind Gegenstand abhängiger Unteransprüche.

Der der Erfindung zu Grunde liegende Gedanke besteht darin, bei der gerichteten Erstarrung, welche, wie oben dargelegt, Bestandteil jedes derzeit relevanten Herstellungsverfahrens für solartaugliches Silizium ist, effizienter zu gestalten. Dies erfolgt dadurch, dass bei dem gerichteten Erstarren eine Kristallisationsfront ausgebildet wird, welche die Form wenigstens eines Abschnittes einer Kugeloberfläche aufweist.

Hierdurch erhält die Kristallisationsfront die größtmögliche Oberfläche. Da die Reinigungswirkung während der gerichteten Erstarrung von der Größe der Oberfläche der Kristallisationsfront abhängt, wird hierdurch die Reinigungswirkung während einer gerichteten Erstarrung verbessert. In Folge kann die Herstellung von solartauglichem Silizium aufwandsgünstiger und somit kostengünstiger erfolgen, da zumindest auf einen Teil weiterer Reinigungs- oder Aufbereitungsschritte verzichtet werden kann.

Der Vorteil der aufwandsgünstigen Herstellung solartauglichen Siliziums wirkt sich auch vorteilhaft auf die aus diesem Material gefertigten Siliziumscheiben (Wafer) und Solarzellen aus. Vorteilhafterweise werden daher Siliziumscheiben und/oder Solarzellen zumindest teilweise aus Silizium gefertigt, welches nach dem erfindungsgemäßen Verfahren hergestellt wurde.

Im Folgenden wird die Erfindung anhand von Zeichnungen näher erläutert. Dabei wird stets von der Verwendung metallurgischen Siliziums als Ausgangsmaterial für die gerichtete Erstarrung ausgegangen, da bei diesem unreinen Material die Vorteile der Erfindung sich besonders stark auswirken. Die Verfahrensschritte lassen sich jedoch ohne weiteres auf ein Verfahren übertragen, bei welchem aus der Dampfphase von Silanverbindungen abgeschiedenes Silizium als Ausgangsmaterial für die gerichtete Erstarrung dient.

Es zeigen:
- Figur 1:: Schematische Darstellung eines ersten Ausführungs- beispiels des erfindungsgemäßen Verfahrens zur Her- stellung solartauglichen Siliziums.
- Figur 2:: Prinzipdarstellung eines zweiten Ausführungsbeispie- la des erfindungsgemäßen Verfahrens aufweisend den Verfahrensschritt der carbothermischen Reduktion von Siliziumdioxid mittels Kohlenstoff zu metallurgi- schem Silizium.
- Figur 3:: Illustration eines dritten Ausführungsbeispiels des erfindungsgemäßen Verfahrens, bei welchem eine zu- sätzliche gerichtete Erstarrung mit ebener Kristal- lisationsfront vorgesehen ist.
- Figur 4:: Prinzipdarstellung eines vierten Ausführungsbei- spiels des Verfahrens gemäß der Erfindung. Die zu- sätzliche gerichtete Erstarrung erfolgt hier mit zu- mindest teilweise sphärischer Kristallisationsfront.
- Figur 5a:: Schematische Schnittdarstellung einer Kristallisati- onsfront, welche die Form eines Abschnittes einer Kugeloberfläche aufweist. Das Erstarren erfolgt hier ausgehend von der Oberfläche der Siliziumschmelze.
- Figur 5b:: Schematische Schnittdarstellung einer halbkugelför- migen Kristallisationsfront, welche ihren Ausgang an einem Ort am Boden des Tiegels nimmt.
- Figur 5c:: Illustration einer kugelförmigen Kristallisations- front mit Hilfe einer Schnittdarstellung. Das Er- starren erfolgt ausgehend von einem im Volumen der Schmelze gelegenen Ort.

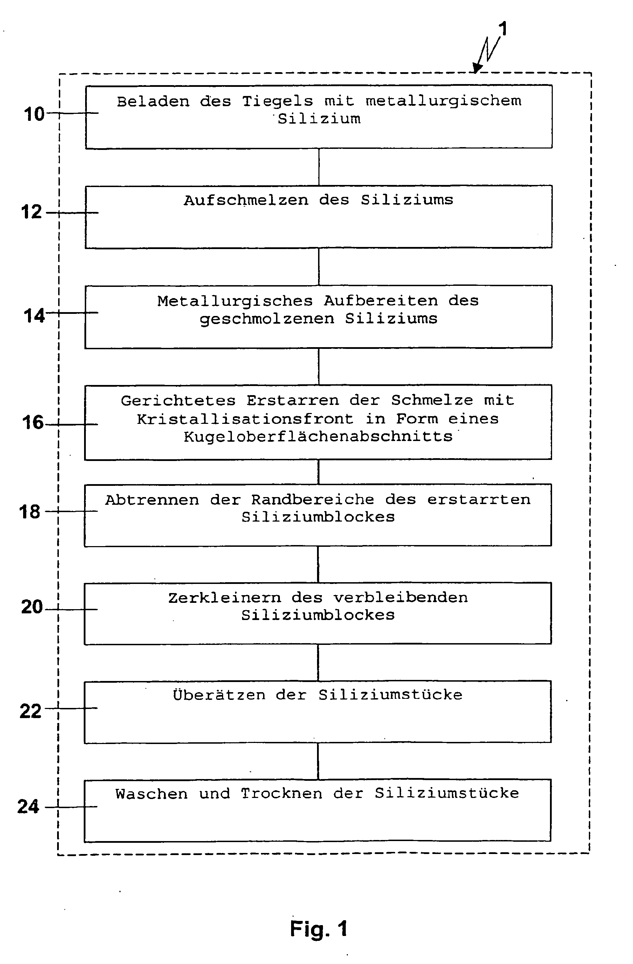

Figur 1 zeigt ein erstes Ausführungsbeispiel 1 des erfindungsgemäßen Verfahrens. Gemäß diesem wird zunächst ein Tiegel mit metallurgischem Silizium beladen 10. In diesem Tiegel wird das metallurgische Silizium sodann aufgeschmolzen 12. Im Anschluss wird das Silizium mittels metallurgische Methoden aufbereitet 14, d.h. gereinigt.

Wie bereits einleitend erwähnt sind neben Metallen die Dotierstoffe Bor (B) und Phosphor (P) die Verunreinigungen mit großer Bedeutung. Ein bekanntes metallurgisches Verfahren zur Entfernung des P besteht beispielsweise darin, die Schmelze sehr starken Unterdrücken auszusetzen und hierdurch die Ausdiffusion des P aufgrund dessen hohen Dampfdruckes zu bewirken. Daneben kann B durch oxidative Reinigungsschritte entfernt werden. Hierzu wird als oxdidierendes Spülgas beispielsweise Wasserdampf, Kohlendioxid oder Sauerstoff durch die Schmelze hindurchgeführt (meist gemischt mit inerten Gasen wie Edelgasen oder Stickstoff).

Alternativ oder zusätzlich können auch metallurgische Reinigungsschritte vorgesehen werden, bei welchen der Schmelze, wie bei der Metallherstellung oder -veredelung, Stoffe beigemengt werden, welche unerwünschte Verunreinigungen chemisch oder physikalisch binden und eine Schlacke bilden, welche aufgrund anderer physikalischer Eigenschaften als die Siliziumschmelze, z.B. geringere oder höhere spezifische Dichte, von der Siliziumschmelze separiert. Beilspielsweise kann die Schlacke aufgrund geringerer spezifischer Dichte auf der Siliziumschmelze schwimmen.

Diese und ähnliche Verfahren können auch zur Reduktion der Sauerstoff- und/oder Kohlenstoffverunreinigungen Verwendung finden.

Nach der Aufbereitung 14 erfolgt eine gerichtetes Erstarren 16 der Siliziumschmelze, bei welcher eine Kristallisationsfront ausgebildet wird, welche die Form wenigstens eines Abschnittes einer Kugeloberfläche aufweist, sozusagen wenigstens teilweise sphärisch ist.

Hierzu wird eine lokale Temperatursenke an oder in die Schmelze gebracht. Als solche kann beispielsweise eine gekühlte Spitze eines Stabes dienen, welcher an die Schmelze herangeführt wird.

Bei der Wahl der Materialien derjenigen Teile der Temperatursenke, welche mit der Siliziumschmelze in Kontakt geraten, ist darauf zu achten, dass diese nicht als Kontaminationsquelle dienen.. Um dies zu vermeiden können die Oberflächen dieser Teile beispielsweise mit einem hitzebeständigen Dielektrikum wie Siliziumnitrid beschichtet sein, welches einen Eintrag

Daneben kann auch eine Graphitbeschichtung oder aus Graphit oder anderen Kohlenstoffformen gebildete Temperatursenke verwendet werden. Kohlenstoff ist zwar, wie oben erläutert, selbst eine unerwünschte Verunreinigung der Schmelze, doch fällt dessen schädlicher Einfluss auf die Solarzellenherstellung deutlich geringer aus als bei den meisten metallischen Verunreinigungen. Bei Ausbildung einer möglichst geringen Kontaktfläche zwischen dem Kohlenstoff und der Siliziumschmelze kann die Kohlenstoffkontamination daher trotz direktem Kontakt mit der Schmelze am Ende des Herstellungsprozesses in einem tolerablen Rahmen liegen.

Die lokale Temperatursenke dient gleichsam als Kristallisationskeim, so dass von dieser aus sich die Kristallisation sphärisch ausbreitet und sich in der Schmelze eine sphärische Kristallisationsfront einstellt. Die Temperatur der Siliziumschmelze ist dabei vor Kontakt mit der Temperatursenke offensichtlich derart einzustellen, dass der Kontakt mit der Temperatursenke ausreicht, um die Kristallisation auszulösen.

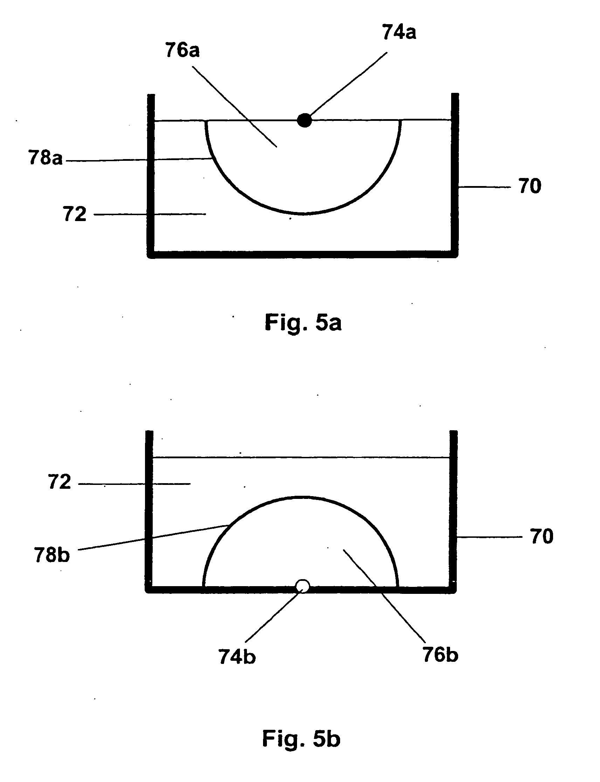

In welcher Weise die Ausbildung einer Kristallisationsfront, welche die Form wenigstens eines Abschnittes einer Kugeloberfläche aufweist, erfolgen kann, illustrieren die Figuren 5a bis 5c. In diesen ist jeweils ein die Siliziumschmelze 72 enthaltender Tiegel 70 in einer Schnittdarstellung schematisch wiedergegeben.

Figur 5a verdeutlicht eine von der Oberfläche der Siliziumschmelze ausgehende Erstarrung. Eine Temperatursenke wird and die oberseitige Oberfläche der Schmelze herangeführt und bildet dort den im Wesentlichen punktförmigen Kristallisationsursprung 74a aus. An diesem setzt die Kristallisation ein. Diese wird durch entsprechende Temperaturführung in der Siliziumschmelze fortgesetzt, sodass sich eine Kristallisationsfront 78a in Form einer Kugelhalbschale ausbildet. Innerhalb dieser sich in der Siliziumschmelze radial ausbreitenden Kristallisationsfront liegt erstarrtes und durch den Segregationseffekt gereinigtes Silizium 76a vor. Außerhalb der Kugelhalbschale 78a liegt weiterhin flüssiges Silizium vor.

Figur 5b verdeutlicht, wie eine vom Boden des Tiegels 70 ausgehende Erstarrung erfolgt. Die Temperatursenke ist hier in dem Tiegel 70 angeordnet, so dass der Kristallisationsursprung 74b unmittelbar am Boden des Tiegels 70 liegt. Von dort breitet sich wiederum eine kugelhalbschalenförmige Kristallisationsfront 78b radialsymmetrisch in der Siliziumschmelze 72 aus. Innerhalb der Kugelhalbschale liegt wiederum erstarrtes Silizium 76 vor, während im Außenbereich sich weiterhin die Siliziumschmelze 72 befindet.

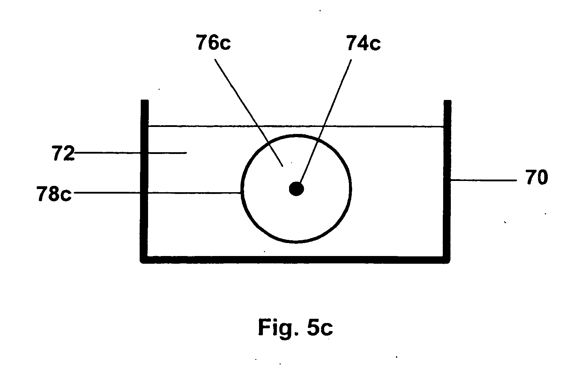

In Figur 5c ist weiter eine Erstarrung dargestellt, welche von einem Ort im Volumen der Schmelze 72 ausgeht. Der Kristallisationsursprung 74c liegt hier also im Siliziumvolumen 72. In diesem Fall bildet sich, wie in Figur 5c erkennbar, eine vollständige, sphärische Kristallisationsfront 78c aus. In dem von der Kristallisationsfront 78c eingeschlossenen Volumen liegt erstarrtes Silizium 76c vor, während sich außerhalb weiterhin noch die Siliziumschmelze 72 befindet.

Die Figuren 5a bis 5c zeigen jeweils Momentaufnahmen der sich ausbreitenden Kristallisationsfronten 78a, 78b, 78c. Diese breiten bei entsprechender Temperaturführung in der Siliziumschmelze 72 weiterhin radialsymmetrisch aus, bis sie den Tiegel 70 erreicht haben. Aus diesem Grund wird der Kristallisationsursprung 74a, 74b, 74c bevorzugt derart positioniert, dass die Kristallisationsfronten 78a, 78b, 78c in allen Raumrichtungen möglichst gleichzeitig die Wandungen des Tiegels 70 erreichen. Die Geometrie des Tiegels 70 ist vorzugsweise dementsprechend angepasst, bei einer im Zentrum des Volumens der Siliziumschmelze 72 gelegenen Kristallisationsfront 78c beispielsweise quadratisch ausgebildet. Dies ermöglicht eine möglichst geringe Erstarrungszeit. Prinzipiell kann der Kristallisationsursprung jedoch in jeden beliebigen Ort in der Siliziumschmelze 72 oder an deren Oberfläche gelegt werden, beispielsweise auch an die Seitenwände des Tiegels 70.

Nach vollständigem Erstarren 16 der Schmelze sind Verunreinigungen mit erhöhter Konzentration in den zuletzt erstarrten Bereichen vorhanden. Daher erfolgt nun, wie in Figur 1 dargestellt, ein Abtrennen 18 der Randbereiche des erstarrten Siliziumblockes.

Im Weiteren wird der erstarrte Siliziumblock zerkleinert 20. Bei dem Siliziumblock handelt es sich um polykristallines Silizium, welches Korngrenzen enthält. Bei der Zerkleinerung des Siliziumblockes bricht dieser bevorzugt entlang von Korngrenzen, so dass diese an der Oberfläche der Siliziumstücke liegen. Darüber hinaus lagern sich Verunreinigungen verstärkt an Korngrenzen an, so dass auch diese bei den Siliziumstücken an der Oberfläche liegen.

Im folgenden Schritt des Überätzens 22 der Siliziumstücke können diese gelöst und somit entfernt werden. Es folgt ein Waschen und Trocknen 24 der Siliziumstücke zur Entfernung bzw. Neutralisierung der Ätzlösung.

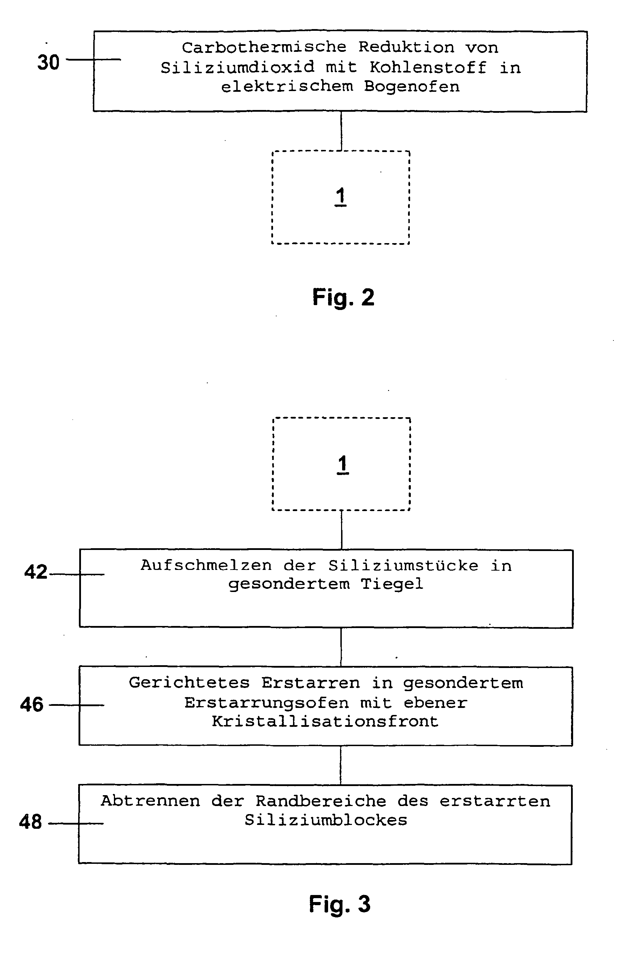

Figur 2 zeigt ein weiteres Ausführungsbeispiel des erfindungsgemäßen Verfahrens. Dieses weist sämtliche Verfahrensschritte des ersten Ausführungsbeispiels 1 aus Figur 1 auf, wie dies grafisch angedeutet ist. Den Verfahrensschritten des ersten Ausführungsbeispiels 1 geht jedoch zusätzlich die carbothermische Reduktion 30 von Siliziumdioxid mit Kohlenstoff in einem elektrischen Bogenofen voran.

Figur 3 zeigt ein drittes Ausführungsbeispiel des erfindungsgemäßen Verfahrens. Dieses umfasst, wie schematisch angedeutet, wiederum die Verfahrensschritte des ersten Ausführungsbeispiels 1. Darüber hinaus werden am Ende des Verfahrens nach dem ersten Ausführungsbeispiel 1 die Siliziumstücke in einem gesonderten Tiegel nochmals aufgeschmolzen 42. Dieser gesonderte Tiegel weist eine geringere Kontamination auf als der beim Aufschmelzen des metallurgischen Siliziums verwendete Tiegel. Hierdurch wird ein Verunreinigungseintrag in die aus bereits gereinigten Siliziumstücke bestehende Schmelze verhindert.

Es folgt ein gerichtetes Erstarren 46, was aus den soeben beschriebenen Kontaminationserwägungen in einem gesonderten Erstarrungsofen durchgeführt wird, wobei eine ebene Kristallisationsfront ausgebildet wird. Entlang der fortschreitenden ebenen Kristallisationsfront erfolgt über die beschriebenen Segregationseffekte ein weitere Reinigung des Siliziummaterials.

Im Anschluss werden wiederum die Randbereiche des erstarrten Silizumblockes abgetrennt 48. Bei reinem öder entsprechend ausgekleidetem Tiegel kann auch erwogen werden, nur die Boden- und Kappenbereiche des erstarrten Siliziumblockes, d.h. die zuerst und die zuletzt erstarrten Bereiche, oder gar nur den zuletzt erstarrten Bereich abzutrennen, da hierin die höchste Verunreinigungskonzentration vorliegt. Im Allgemeinen wird jedoch auch an den übrigen Randbereichen eine erhöhte Verunreinigung vorliegen, so dass diese vorteilhafterweise abgetrennt werden.

Damit liegt zusätzlich gereinigtes Siliziummaterial vor. Die beschriebene zusätzliche Reinigung kann insbesondere dann erforderlich sein, um solartaugliches Siliziummaterial zu erhalten, wenn das Ausgangsmaterial relativ stark verunreinigt ist.

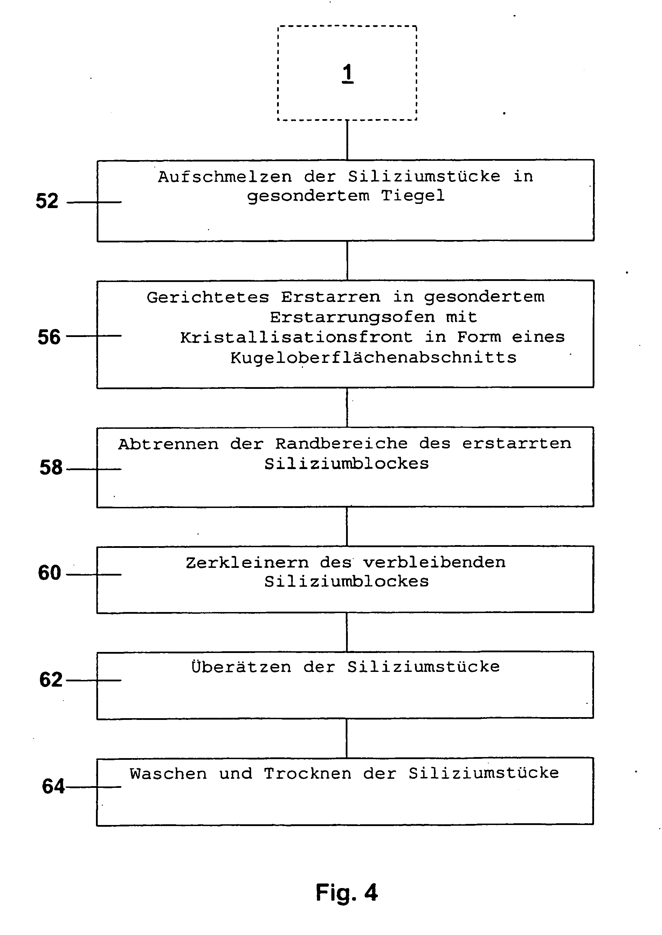

Figur 4 gibt ein viertes Ausführungsbeispiel des erfindungsgemäßen Verfahrens wieder. Den Ausgangspunkt bilden ähnlich wie beim dritten Ausführungsbeispiel die Verfahrensschritte des ersten Ausführungsbeispiels 1. Analog dem dritten Ausführungsbeispiel werden auch hier die Siliziumstücke nochmals in einem gesonderten Tiegel aufgeschmolzen 52. Hernach folgt wiederum ein gerichtetes Erstarren 56, wobei im Gegensatz zum dritten Ausführungsbeispiel hier auch beim zweiten Erstarrungsvorgang eine Kristallisationsfront in Form wenigstens eines Abschnitts einer Kugeloberfläche erfolgt, was die oben beschriebenen Vorteile mit sich bringt.

Im Anschluss folgt erneut ein Abtrennen 58 der Randbereiche des erstarrten Siliziumblockes. Dem schließt sich ein Zerkleinern 60 des verbleibenden Siliziumblockes an, so dass die resultierenden Siliziumstücke, welche vorzugsweise einen Durchmesser von etwa 5 mm aufweisen, überätzt 62 werden können. Letztlich erfolgt wiederum ein Waschen und Trocknen 64 der Siliziumstücke. Dieses zusätzliche Überätzen kann selbstverständlich auch bei einem der anderen Ausführungsbeispiele vorgenommen werden.

### Bezugszeichenliste

- 1: Erstes Ausführungsbeispiel
- 10: Beladen des Tiegels mit metallurgischem Silizium
- 12: Aufschmelzen des Siliziums
- 14: Metallurgisches Aufbereiten der Siliziumschmelze
- 16: Gerichtetes Erstarren der Schmelze mit Kristallisations- front in Form eines Kugeloberflächenabschnitts
- 18: Abtrennen der Randbereiche des erstarrten Siliziumblockes
- 20: Zerkleinern des verbleibenden Siliziumblockes
- 22: Überätzen der Siliziumstücke
- 24: Waschen und Trocknen der Siliziumstücke

- 30: Carbothermische Reduktion von Siliziumdioxid mit Kohlen- stoff in elektrischem Bogenofen

- 42: Aufschmelzen der Siliziumstücke in gesondertem Tiegel
- 46: Gerichtetes Erstarren in gesondertem Erstarrungsofen mit ebener Kristallisationsfront
- 48: Abtrennen der Randbereiche des erstarrten Siliziumblockes

- 52: Aufschmelzen der Siliziumstücke in gesondertem Tiegel
- 56: Gerichtetes Erstarren in gesondertem Erstarrungsofen mit Kristallisationsfront in Form eines Kugeloberflächenab- schnitts
- 58: Abtrennen der Randbereiche des erstarrten Siliziumblockes
- 60: Zerkleinern des verbleibenden Siliziumblockes
- 62: Überätzen der Siliziumstücke
- 64: Waschen und Trocknen der Siliziumstücke

- 70: Tiegel
- 72: Siliziumschmelze
- 74a: Kristallisationsursprung
- 74b: Kristallisationsursprung
- 74c: Kristallisationsursprung
- 76a: erstarrtes Silizium
- 76b: erstarrtes Silizium
- 76c: erstarrtes Silizium
- 78a: Kristallisationsfront
- 78b: Kristallisationsfront
- 78c: Kristallisationsfront

## Patentansprüche

1. Verfahren zur Herstellung von solartauglichem Silizium, aufweisend die Verfahrensschritte
- des Aufschmelzens von Silizium und
- des gerichteten Erstarrens der Schmelze,
**dadurch gekennzeichnet,**
**dass** bei dem gerichteten Erstarren eine Kristallisationsfront ausgebildet wird, welche die Form wenigstens eines Abschnittes einer Kugeloberfläche aufweist.

2. Verfahren nach Anspruch 1,
**dadurch gekennzeichnet,**
**dass** sich die Kristallisationsfront in der Schmelze radialsymmetrisch ausbreitet.

3. Verfahren nach einem der Ansprüche 1 bis 2,
**dadurch gekennzeichnet,**
**dass** das Erstarren von der Oberfläche der Schmelze ausgehend erfolgt.

4. Verfahren nach einem der Ansprüche 1 bis 2,
**dadurch gekennzeichnet,**
**dass** das Erstarren von einem in dem Volumen der Schmelze liegenden Ort ausgehend erfolgt.

5. Verfahren nach Anspruch 3,
**dadurch gekennzeichnet,**
**dass** die Schmelze sich in einem Tiegel befindet und das Erstarren von einem Ort am Boden des Tiegels ausgehend erfolgt.

6. Verfahren nach einem der Ansprüche 1 bis 5,
**dadurch gekennzeichnet,**
**dass** metallurgisches Silizium aufgeschmolzen wird.

7. Verfahren nach Anspruch 6,
**dadurch gekennzeichnet,**
**dass** das metallurgische Silizium aus einer carbothermischen Reduktion von Siliziumdioxid mittels Kohlenstoff gewonnen wird.

8. Verfahren nach Anspruch 7,
**dadurch gekennzeichnet,**
**dass** die carbothermische Reduktion in einem Bogenofen durchgeführt wird.

9. Verfahren nach einem der Ansprüche 6 bis 8,
**dadurch gekennzeichnet,**
**dass** das aufgeschmolzene metallurgische Silizium vor der Erstarrung in einem Aufbereitungsofen metallurgisch aufbereitet wird, wobei bei der metallurgischen Aufbereitung vorzugsweise die Schmelze mit einem Spülgas gereinigt wird und/oder Schlackebildner zugesetzt werden.

10. Verfahren nach Anspruch 9,
**dadurch gekennzeichnet,**
**dass** die Erstarrung in dem Aufbereitungsofen durchgeführt wird.

11. Verfahren nach einem der Ansprüche 1 bis 10,
**dadurch gekennzeichnet,**
**dass** nach dem Erstarren der Schmelze an jeder Seite des erstarrten Siliziumblockes ein Randbereich entfernt wird, wobei der Randbereich vorzugsweise wenige Zentimeter dick ist.

12. Verfahren nach Anspruch 11,
**dadurch gekennzeichnet,**
**dass** der verbleibende Siliziumblock zerkleinert und mit einer Ätzlösung überätzt wird, wobei die aus der Zerkleinerung resultierenden Siliziumstücke vorzugsweise einen Durchmesser von etwa fünf Millimetern aufweisen.

13. Verfahren nach Anspruch 12,
**dadurch gekennzeichnet,**
**dass** die Siliziumstücke nach der Überätzung gewaschen und getrocknet werden.

14. Verfahren nach einem der Ansprüche 11 bis 13,
**dadurch gekennzeichnet,**
**dass** der Siliziumblock bzw. die Siliziumstücke erneut aufgeschmolzen werden und eine weitere gerichtete Erstarrung erfolgt.

15. Verfahren nach Anspruch 14,
**dadurch gekennzeichnet,**
für das erneute Aufschmelzen ein gesonderter Tiegel vorgesehen wird und/oder das Aufschmelzen in einem gesonderten Erstarrungsofen erfolgt.

16. Verfahren nach einem der Ansprüche 14 bis 15,
**dadurch gekennzeichnet,**
**dass** die weitere gerichtete Erstarrung nach einem der Ansprüche 1 bis 5 durchgeführt wird.

17. Verfahren nach einem der Ansprüche 14 bis 16,
**dadurch gekennzeichnet,**
**dass** nach der weiteren gerichteten Erstarrung der Schmelze an jeder Seite des erstarrten Siliziumblockes ein Randbereich entfernt wird, wobei der Randbereich vorzugsweise wenige Zentimeter dick ist.

18. Verfahren nach Anspruch 17,
**dadurch gekennzeichnet,**
**dass** der verbleibende Siliziumblock zerkleinert und mit einer Ätzlösung überätzt wird, wobei die aus der Zerkleinerung resultierenden Siliziumstücke vorzugsweise einen Durchmesser von etwa fünf Millimetern aufweisen.

19. Verfahren nach Anspruch 18,
**dadurch gekennzeichnet,**
**dass** die Siliziumstücke nach der Überätzung gewaschen und getrocknet werden.

## Claims

1. A method for the production of solar grade silicon, comprising the steps of
- melting the silicon and
- directionally solidifying the melt,
**characterized in that** a crystallization front is formed during the directional solidification, said crystallization front having the shape of at least a section of a spherical surface.

2. Method according to claim 1,
**characterized in that**
the crystallization front propagates radial-symmetrically in the melt.

3. Method according to any of claims 1 to 2,
**characterized in that**
the solidification starts from the surface of the melt.

4. Method according to any of claims 1 to 2,
**characterised in that**
the solidification starts from a place located in the volume of the melt.

5. Method according to claim 3,
**characterized in that**
the melt is in a crucible and the solidification starts from a place on the bottom of the crucible.

6. Method according to any of claims 1 to 5,
**characterised in that**
metallurgical silicon is melted.

7. Method according to claim 6,
**characterized in that**
the metallurgical silicon is extracted by means of a carbothermal reduction of silicon dioxide with carbon.

8. Method according to claim 7,
**characterized in that**
the carbothermal reduction is carried out in an electric arc furnace.

9. Method according to any of claims 6 to 8,
**characterized in that**
prior to the solidification, the molten metallurgical silicon is metallurgically processed in a processing furnace, whereby the melt is preferably purified with a purge gas and/or slag-forming constituents are added during the metallurgical processing.

10. Method according to claim 9,
**characterized in that**
the solidification is carried out in the processing furnace.

11. Method according to any of claims 1 to 10,
**characterized in that**
after the melt has solidified, an edge area on each side of the solidified silicon ingot is removed, whereby the edge area is preferably a few centimeters thick.

12. Method according to claim 11,
**characterized in that**
the remaining silicon ingot is comminuted and overetched with an etching solution, whereby the silicon fragments resulting from the comminution preferably have a diameter of about 5 millimeters.

13. Method according to claim 12,
**characterized in that**
the silicon fragments are washed and dried after the overetching.

14. Method according to any of claims 11 to 13,
**characterized in that**
the silicon ingot or the silicon fragments are melted again and further directional solidification takes place.

15. Method according to claim 14,
**characterized in that**
in order to repeat the melting, a separate crucible is provided and/or the melting takes place in a separate solidification furnace.

16. Method according to claim 14 or 15,
**characterised in that**
the further directional solidification is carried out according to any of claims 1 to 5.

17. Method according to any of claims 14 to 16,
**characterized in that**
after the further directional solidification, an edge area on each side of the solidified silicon ingot is removed, whereby the edge area is preferably a few centimeters thick.

18. Method according to claim 17,
**characterized in that** the remaining silicon ingot is comminuted and overetched with an etching solution, whereby the silicon fragments resulting from the comminution preferably have a diameter of about 5 millimeters.

19. Method according to claim 18,
**characterized in that**
after the overetching, the silicon fragments are washed and dried.

## Revendications

1. Procédé pour la production de silicium de qualité solaire présentant les étapes de procédé
- de la fonte du silicium et
- de la solidification directionnelle de la masse fondue,
**caractérisé en ce**
**qu'**un front de cristallisation, qui présente la forme d'au moins une section d'une surface sphérique, est formé lors de la solidification directionnelle.

2. Procédé selon la revendication 1,
**caractérisé en ce**
**que** le front de cristallisation se répand dans la masse fondue de façon radialement symétrique.

3. Procédé selon l'une des revendications 1 à 2,
**caractérisé en ce**
**que** la solidification s'effectue en partant de la surface de la masse fondue.

4. Procédé selon l'une des revendications 1 à 2,
**caractérisé en ce**
**que** la solidification s'effectue en partant d'un endroit situé dans le volume de la masse fondue.

5. Procédé selon la revendication 3,
**caractérisé en ce**
**que** la masse fondue se trouve dans un creuset et la solidification s'effectue en partant d'un endroit au fond du creuset.

6. Procédé selon l'une des revendications 1 à 5,
**caractérisé en ce**
**que** du silicium métallurgique est fondu.

7. Procédé selon la revendication 6,
**caractérisé en ce**
**que** le silicium métallurgique est obtenu par une réduction carbothermique de dioxyde de silicium au moyen de carbone.

8. Procédé selon la revendication 7,
**caractérisé en ce**
**que** la réduction carbothermique est exécutée dans un four à arc.

9. Procédé selon l'une des revendications 6 à 8,
**caractérisé en ce**
**que** le silicium métallurgique fondu subit un traitement métallurgique avant la solidification dans un four de traitement, cependant que, lors du traitement métallurgique, de préférence la masse fondue est purifiée avec un gaz de lavage et/ou des fondants de scorification sont ajoutés.

10. Procédé selon la revendication 9,
**caractérisé en ce**
**que** la solidification est exécutée dans un four de traitement.

11. Procédé selon l'une des revendications 1 à 10,
**caractérisé en ce**
**qu'**une zone marginale est enlevée, après solidification de la masse fondue, de chaque côté du bloc de silicium solidifié, la zone marginale ayant de préférence une épaisseur de quelques centimètres.

12. Procédé selon la revendication 11,
**caractérisé en ce**
**que** le bloc de silicium restant est broyé et surgravé avec une solution d'attaque, les morceaux de silicium qui résultent du broyage présentant, de préférence, un diamètre d'environ cinq millimètres.

13. Procédé selon la revendication 12,
**caractérisé en ce**
**que** les morceaux de silicium sont lavés et séchés après la surgravure.

14. Procédé selon l'une des revendications 11 à 13,
**caractérisé en ce**
**que** le bloc de silicium ou les morceaux de silicium sont fondus à nouveau et une nouvelle solidification directionnelle a lieu.

15. Procédé selon la revendication 14,
**caractérisé en ce**
**qu'**un creuset séparé est prévu pour la nouvelle fusion et/ou la fusion a lieu dans un four de solidification séparé.

16. Procédé selon l'une des revendications 14 à 15,
**caractérisé en ce**
**que** la nouvelle solidification directionnelle est exécutée selon l'une des revendications 1 à 5.

17. Procédé selon l'une des revendications 14 à 16,
**caractérisé en ce**
**qu'**une zone marginale est enlevée, après la nouvelle solidification de la masse fondue, de chaque côté du bloc de silicium solidifié, la zone marginale ayant de préférence une épaisseur de quelques centimètres.

18. Procédé selon la revendication 17,
**caractérisé en ce**
**que** le bloc de silicium restant est broyé et surgravé avec une solution d'attaque, les morceaux de silicium qui résultent du broyage présentant, de préférence, un diamètre d'environ cinq millimètres.

19. Procédé selon la revendication 18,
**caractérisé en ce**
**que** les morceaux de silicium sont lavés et séchés après la surgravure.
